# EUROPEAN PATENT SPECIFICATION

(11) **EP 0 890 996 B1**
(45) Date of publication and mention of the grant of the patent: **25.10.2006**
(21) Application number: 98112602.2
(22) Date of filing: 07.07.1998
(51) Int. Cl.: H01L 33/00

(54) **Transparent coating member for light-emitting diodes and fluorescent color light source**
Durchsichtige Beschichtung für Leuchtdioden und fluoreszierende Lichtquellen
Revêtement transparent pour des diodes électroluminescentes et soruce de lumière fluorescente

(30) Priority: 07.07.1997 JP 18103597
(43) Date of publication of application: 13.01.1999
(73) Proprietor: Asahi Rubber Inc., Saitama-shi, Saitama (JP); SANKEN ELECTRIC CO., LTD., Niiza-shi Saitama (JP)
(72) Inventor: Tasaki, Masutsugu c/o Asahi Rubber Inc.,, Nishishirakawa-gun, Fukushima-ken (JP); Ichikawa, Akira c/o Asahi Rubber Inc.,, Nishishirakawa-gun, Fukushima-ken (JP); Odaki, Tsutomu c/o Asahi Rubber Inc.,, Nishishirakawa-gun, Fukushima-ken (JP); Takagi, Kazuhisa c/o Kabushiki Kaisha Fine Rubber, Nishishirakawa-gun, Fukushima-ken (JP)
(74) Representative: Müller-Boré & Partner Patentanwälte

(56) References cited:
- WO-A-97/50132
- DE-A- 3 804 293
- JP-A- 1 260 707
- JP-A- 6 104 491
- JP-A- 48 112 276
- JP-A- 58 196 067
- US-A- 3 593 055
- US-A- 3 932 881
- US-A- 3 959 655
- US-A- 4 599 537
- SATO Y ET AL: "FULL-COLOR FLUORESCENT DISPLAY DEVICES USING A NEAR-UV LED" JAPANESE JOURNAL OF APPLIED PHYSICS, vol. 35, no. 7A, 1 July 1996 (1996-07-01), pages L838-L839, XP000733074 ISSN: 0021-4922

## Description

This invention relates to a transparent coating member to be engaged with the surface of a light-emitting diode (hereinafter, "LED") and a light source for changing the color of a light emitted from an LED by being engaged with said coating member.

As well-known, a LED chip is a crystal body having a p-n junction. Upon the application of a forward voltage, electrons are injected from the n region to the p-n junction and holes are injected from p region to the p-n junction. A light is emitted when the electrons and holes are recombined. Accordingly, free electrons are combined and energy released during this recombination is radiated as a light. Thus, there exist LEDs of limited colors. In other words, LEDs having a red LED chip emit only a red light; LEDs having a green LED chip emit only a green light; and LEDs having a blue LED chip emit only a blue light.

However, there has recently been a large demand for LEDs capable of changing a light emitted therefrom in order to meet multi-purpose applications. A color changing method for meeting such a demand is, for example, such that a suitable combination of red, green and blue LED chips are set in the LED and the color of the light emitted from the LED is changed by causing a different combination of chips to emit light.

Such an LED results in a complicated constructional design since four terminals: three different anode terminals of the red, green and blue LED chips and a cathode terminal, are necessary. The most fatal problem is that, since three different chips are set in the LED, a color balance is lost if any one of the chips is broken, with the result that a desired color cannot be obtained.

Further, in recent years, a white LED lamp has been proposed in which a layer of YAG (yttrium aluminate) fluophor is provided on a blue LED chip (Nikkei Sangyo Shinbun, Sept. 13, 1991 issue). This white LED lamp is designed to generate a white light by a light excited by the layer of fluophor and the afterglow of the blue LED chip. If a cap or a sheet containing a coloring agent is mounted on such a white LED lamp, a light of a desired color can be obtained.

However, the above white LED lamp has various problems that a high degree of application technique is required due to only a very small amount of fluorescent substance on the blue LED chip, a large variation of the color caused by a slight error and the application of a fine amount, and a price per lamp is very expensive.

On the other hand, it is in reality very difficult to produce LEDs of uniform quality, and the color and luminance of the produced LEDs unavoidably vary. It is a very important problem how such variations can be suppressed without increasing production costs. Up to now, the variations have not yet sufficiently been suppressed.

DE 38 04 293 A1 discloses a light source comprising an LED chip, whose emitting surface is covered by a plastic element made of polycarbonate and comprising an organic fluorescent substance.

US 3 959 655 discloses a light source including a light emitting diode chip covered by a thin sheet of transparent material containing a fluorescent dye used to concentrate the output of the light emitting diode chip to a fine line.

US 3 593 055 discloses a light source comprising an infrared-emitting diode chip coated with a phosphor for converting the infrared emission from the LED chip into visible light.

"Full-Color Fluorescent Display Devices Using a Near-UV Light-Emitting Diode, Yuichi Sato et. al, Jpn. J. Appl. Phys., Vol. 35, pp. L838 - L839, Part 2, No. 7A, 1 July 1996, discloses a full-color luminescent display device utilizing a near-UV light-emitting diode, whose light is irradiated onto fluorescent films prepared by spin-coating the suspensions to a glass slide.

US 3 932 881 discloses a light source comprising an infrared-light emitting diode chip and a luminescent material excitable in a step-like manner for converting the infrared radiation to visible rays and an optical cavity enclosing the luminescent material.

US 4 599 537 discloses a light source constituted so that infrared rays and visible rays can be simultaneously emitted. The light source comprises a sealed infrared light emitting diode chip and an infrared visible conversion member made of silicone and comprising an inorganic fluorescent substance.

JP 06 104 491 discloses a light source comprising an encapsulated LED chip and a transparent, coating member, comprising a color agent, mounted onto the surface of the encapsulated LED.

The present invention has been developed as a result of studies to solve the above-mentioned various problems and an object thereof is to provide a transparent coating member for a LED which can easily change the color of a light emitted therefrom to a desired color.

It is another object of the present invention to provide a fluorescent color light source which can easily change the color of a light irradiated therefrom and diffuse the light of a stable color at a high luminance and is easy to maintain and inexpensive.

The invention is directed to a transparent coating member as defined in claim 1.

The invention is also directed to a fluorescent color light source as defined in claim 7.

The wavelength of emitted light peculiar to the light-emitting diode is changed by the fluorescent substance (in the following also abbreviated as "fluophor") contained in the coating portion to change the luminescent color.

These and other objects, features and advantages of the present invention will become more apparent upon a reading of the following detailed description and accompanying drawings.
FIG. 1 is a schematic section of a fluorescent color light source in which a fluorescent color cap as a coating member (cap-shaped) of the invention is mounted on a lamp-type LED;
FIG. 2 is a schematic section of a fluorescent color light source in which a fluorescent color cap as another coating member (cap-shaped) of the invention is mounted on the lamp-type LED;

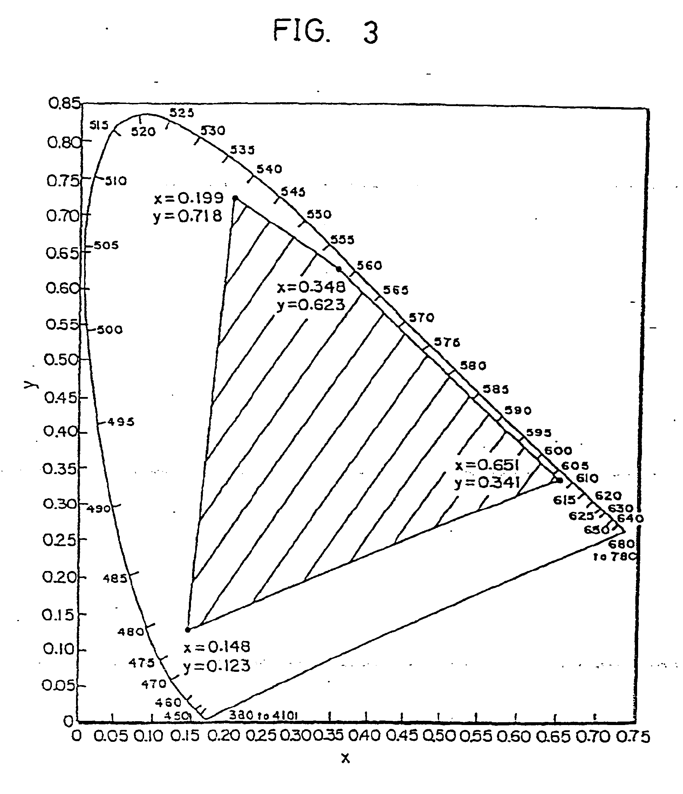

FIG. 3 is a chart showing a variable range of a light diffusely emitted from the fluorescent color source of the invention by CIE (International Committee on Illumination) standard chromaticity diagram;
FIG. 4 is a section of a fluorescent color cap according to the invention in which a light gathering mechanism is provided at its leading end portion;
FIG. 5 is a graph showing a spectral wavelength of a blue LED used in a production example 1;
FIG. 6 is a graph showing a spectral wavelength when the fluorescent color cap is mounted on the blue LED in the production example 1;
FIG. 7 is a graph showing a spectral wavelength when a colored cap is mounted in a production example 3;
FIG. 8 is a graph showing a spectral wavelength when a colored cap is mounted in a production example 4; and
FIG. 9 is a graph showing a spectral wavelength when a fluorescent color cap is mounted in a production example 1.

A significant feature of the transparent coating member for an LED according to the invention lies in the fluorescent substance contained therein. As opposed to the prior art method for generating a light of a desired color by applying a fine amount of fluorescent substance to the LED chip, light of a desired color can be generated by engaging the inventive transparent coating member with an LED without necessitating a high level of technique.

The fluorescent substance may be preferably an yttrium aluminate fluophor. Regarding the cap-shaped coating member, a light gathering mechanism may be provided at a leading end portion thereof.

Also, a fluorescent color light source is produced by engaging the transparent coating member with a light-emitting diode to thereby change the wavelength of an emitted light peculiar to the light-emitting diode by the fluorescent substance contained in the coating member, and thereby change the luminescent color.

The fluorescent color light source is such that the light diffusely emitted through the coating member or coating layer has a luminescent color within a range defined by (x, y) = (0.148, 0.123), (0.199, 0.718), (0.651, 0.341) and (0.343, 0.623) in chromaticity coordinate systems, and more preferably in a range defined by (x, y) = (0.27, 0.19), (0.19, 0.24), (0.35, 0.48) and (0.48, 0.37) in chromaticity coordinate systems. The fluorescent color light source may be such that a coating member or coating layer containing a coloring agent is further mounted or formed on the coating member. Preferably, a holder mechanism may be provided in a desired position of contact surface of the light-emitting diode and the coating member. The light-emitting diode on which the coating member may be preferably mounted is a blue light-emitting diode or green light-emitting diode having a high energy.

The color of emitted light to be diffused while passing through the coating member can be adjusted by partially changing the concentration of the fluorescent substance in the coating member. For example, with reference to a production example 8 to be described later, if the fluorescent substance is uniformly and dispersely mixed in a fluorescent color cap, a light emitted through a leading end portion of the cap is: x = 0.2346, y = 0.2365 and a light emitted through a side surface portion of the cap is: x = 0.3095, y = 0.3389. In other words, the color of the emitted light differs depending on whether the light passes through the leading end portion of the cap or the side surface portion thereof. If another cap containing a specified amount of fluorescent substance is further mounted on the leading end portion of the cap, i.e. the concentration of the fluorescent substance is changed at the leading end portion and the side surface portion, the light emitted through the leading end portion is: x = 0.3060, y = 0.3355 and is the same color as the color of the light emitted through the side surface portion.

Fluorescent substances usable for the inventive transparent coating member for an LED are inorganic fluophors selected from aluminates, phosphates, silicates. Among these substances, yttrium aluminate is particularly preferable since it is usable over a long term.

Additives to be added to the fluophors include, for example, cerium, europium, manganese, gadolinium, samarium, terbium, tin, chromium, etc. Cerium is most preferable among these. An amount of additive is preferably in a range of 0.1 to 10 mol% to the fluophor.

A preferable combination of the fluophor and additive are yttrium aluminate and cerium.

The mode of the inventive transparent coating member for an LED comes in the caplike shape in conformity with the shape of the LED. In order to make the coating member into a caplike shape, for example, the fluorescent substance and a bonding resin may be mixed and the resulting mixture may be molded using a mold and a heat press.

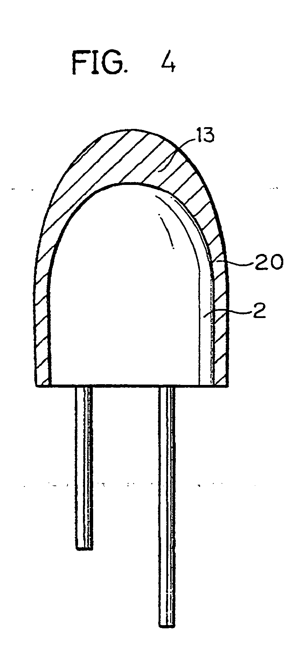

Regarding the transparent coating member for an LED is cap-shaped, a light gathering mechanism may be provided at its leading end portion. Luminance can be increased by such a mechanism, thereby achieving an efficient illumination with a little energy. The light gathering mechanism may be constructed, for example, by a lens construction. A specific example of construction is shown in FIG. 4. A light gathering portion may be provided at the leading end portion of the cap by being integrally molded with other parts using a mold in which the leading end portion is thicker than the other parts or by adhering or mounting a separately manufactured light gathering portion on the leading end portion of the cap.

An amount of the fluorescent substance used in the coating member is preferably in a range of 0.5 to 70 weight parts of inorganic fluophor per 100 weight parts of bonding resin.

Any known LED can be used as an LED used in the present invention. For example, Ga:ZnO red LED, GaP:N green LED, GaAsP red LED, GaAsP orange/yellow LED, GaAlAs LED, InGaAIP orange/yellow LED, GaN blue LED, SiC blue LED, II-VI blue LED may be used.

The wavelength of the light emitted from the LED can be changed to a desired one by mounting the above coating member on the LED.

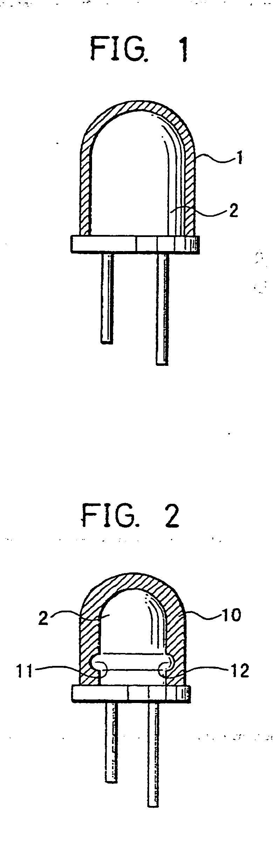

In order to mount the coating member on the LED, it is engaged with the LED. In order to more securely mount the coating member, a holder mechanism may be provided at a peripheral portion of the coating member. With reference to FIG. 1, an inventive coating member (cap) 1 containing a fluorescent substance is directly detachably mounted on an LED 2. Since a cap 10 shown in FIG. 2 is relatively hard, a recess 11 is formed in the cap 10 and a projection 12 is formed on the LED 2 in order to prevent a relative displacement and a disengagement when the cap 10 is mounted on the LED 2. The cap 10 and the LED 2 are disengageably engaged with each other by one operation. The recess 11 and the projection 12 may have an annular configuration along the circumference of the cap or may be formed in a plurality of positions along a circumferential direction at specified intervals. Further, the recess 11 and the projection 12 may be formed on the LED 2 and the cap 10, respectively, converse to the former construction.

The color of the light diffusely emitted from the LED having the coating member mounted thereon or having the coating layer formed thereon is preferably in a range defined by (x, y) = (0.148, 0.123), (0.199, 0.718), (0.651. 0.341), (0.343, 0.623) in the chromaticity coordinate systems. If the emission would fall within such a range, a variety of illuminations could be realized and a color reproduction as a video image is thought to be sufficient. Further, if the color of the emitted light is in a range defined by (x, y) = (0.27, 0.19), (0.19, 0.24), (0.35, 0.48), (0.48, 0.37) in the chromaticity coordinate systems, i.e. it is close to white, the color of the emitted light can easily be adjusted to a desired color.

In other words, if the color of the light emitted from the LED is adjusted to white by mounting the coating member, the emitted light can be adjusted to have a desired color by using a coloring agent. In such a case, the coloring agent may be contained in the coating member together with the fluorescent substance or a separate coating member containing the coloring agent may further be mounted or formed thereon.

The following can be used as a coloring agent. For example, yellow led, yellow zinc, cadmium yellow, yellow iron oxide, mineral fast yellow, nickel titanium yellow, naphthol yellow S, Hansa yellow G, Hansa yellow 10G, benzine yellow G, benzine yellow GR, guinoline yellow lake, permanent yellow NCG, tartrazine lake can be used as a yellow pigment. Chrome orange, molybdenum orange, permanent orange GTR, pyrazolone orange, vulcan orange, benzine orange G can be used as an orange pigment. Condensation azo dye, red iron oxide, cadmium red, red lead, cadmium mercuric sulfide, permanent red 4R, lithol red, pyrazolone red, watching red calcium salt, lake red D, brilliant-carmine 6B, eosine lake, rhodamine lake B, alizarin lake, brilliant-carmine 3B can be used as a red pigment. Manganese violet, fast violet B, methyl violet lake can be used as a violet pigment. Iron blue, cobalt blue, alkali blue lake, Victoria blue lake, phthalocyanine blue, metal-free phthalocyanine blue, phthalocyanine blue partial chloride, fast sky blue can be used as a blue pigment. Chrome green, chromium oxide, pigment green B, malachite green lake can be used as a green pigment. Hydrozincite, titanium oxide, antiony white, zinc sulfide, barite powder, barium carbonate, clay, silica, white carbon, talc, alumina white can be used as a white pigment. It is appropriate to use the above coloring agents in a range of 0.001 to 0.1 weight part, particularly 0.01 to 0.05 weight parts per 100 weight parts of bonding resin.

The LED on which the above coating member is mounted is preferably a blue LED having a high energy. However, it may be a green LED or other LED.

By using the coating member according to the invention, the luminescent color can finely be adjusted. For example, this coating member makes LEDs having an emitted light beyond a permissible range due to a variation during the manufacturing into a one having an emitted light within this permissible range. With reference to a production example 9, a desired luminescent color within a range of x = 0.2886 to 0.3046, y = 0.3102 to 0.3165 can be obtained by mounting a fluorescent color cap containing 10.0 parts of YAG fluophors, 10.5 parts thereof, 11.0 parts thereof, and 11.5 parts thereof on the LED when, for example, a current flowing into a blue LED is 5mA, 10mA, 20mA and 30mA, respectively. It should be noted that the observation or measurement was carried out by means of a spectrophotometer "PR-704" through an integrating sphere or not through an integrating sphere.

### [Examples]

### Production Example 1

40 parts of YAG fluophor (yttrium 28.0 wt%, aluminum 13.6 wt%, gadolinium 56.62 wt%, cerium 1.23 wt%), were dispersed as fluorescent substance in silicone rubber, and a fluorescent color cap having a thickness of 0.6 mm was molded using a mold and a heat press.

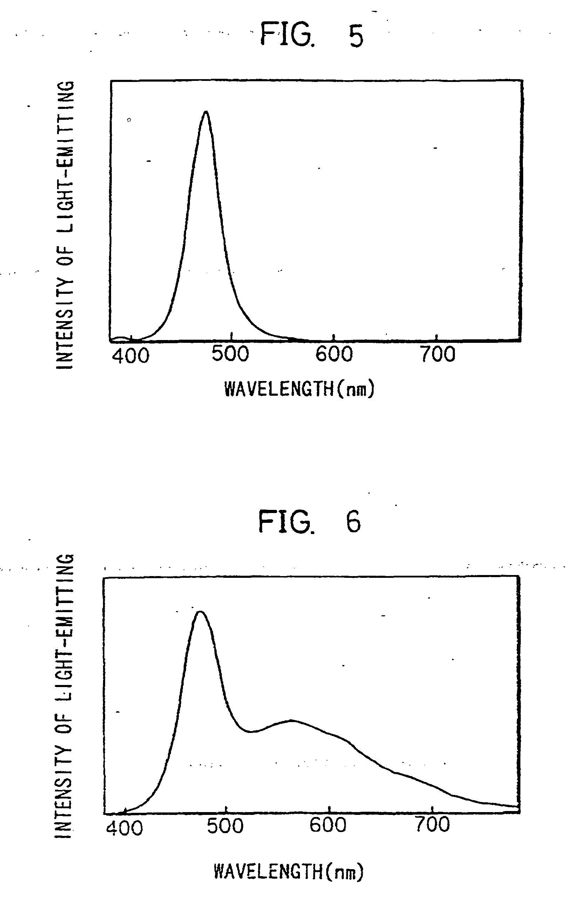

Further, a blue LED which emits a light defined by x = 0.1275, y = 0.0883 in accordance with the chromaticity coordinate systems and having a luminance of 28.95 cd/m² was used. FIG. 5 shows a spectral wavelength of this blue LED. When this blue LED was caused to emit a light with the fluorescent color cap mounted thereon, a diffused white light defined by x = 0.3192, y = 0.3375 in the chromaticity coordinate systems and having a luminance of 66.36 cd/m² was observed. The spectral wavelength at this time is shown in FIG. 6. In this example, the measurement was carried out through the integrating sphere.

### Production Example 2

40 parts of YAG fluophor used in the production example 1 were mixed and dispersed in silicone rubber, and a fluorescent color cap having a thickness of 0.6 mm was produced using a mold and a heat press. A lens-shaped cap made of silicone rubber having a transmittance of 80 % or greater was mounted on a leading end portion of the fluorescent color cap. This fluorescent color cap was mounted on a blue LED, which was then turned on by applying a current of 20 mA. The chromaticity coordinates and luminance were measured from the front of the leading end portion of the LED. The measurement results are shown in TABLE-2. In this example, the measurement was carried out not through the integrating sphere.

**TABLE-2**

| | X | y | Luminance (cd/m²) |
|---|---|---|---|
| Cap Mounted | 0.3446 | 0.3482 | 3667 |
| Lens-Equipped Cap Mounted | 0-3348 | 0.3359 | 6239 |

By providing the lens at the leading end portion of the fluorescent cap, the luminance of the light emitted from the front surface could be increased by about 70 % without changing the luminescent color.

### Production Example 3

12.5 parts of YAG fluophor (yttrium 28.0 wt%, aluminum 13.6 wt%, gadolinium 56.62 wt%, cerium 1.23 wt%) were dispersed as fluorescent substance in silicone rubber, and a fluorescent color cap having a thickness of 0.6 mm was produced using a mold and a heat press.

Using the blue LED used in the production example 1, the above fluorescent color cap was mounted on the blue LED, which was then turned on by applying a current of 20 mA. As a result, a diffused white light defined by x = 0.3192, y = 0.3375 in the chromaticity coordinate systems and having a luminance of 66.36 cd/m² was observed.

On the other hand, 0.03 parts of condensation azo dye were dispersed as a red coloring agent in silicone rubber, and a colored cap having a thickness of 0.5 mm was molded using a mold and a heat press.

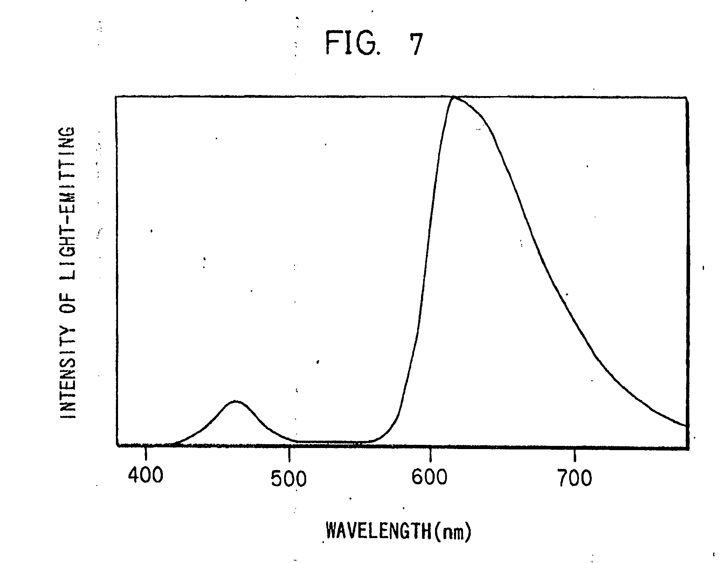

This colored cap was mounted on the LED having the fluorescent color cap mounted thereon, and the LED was caused to emit a light. As a result, a diffused red light defined by x = 0.5997, y = 0.3081 in the chromaticity coordinate systems and having a luminance of 9.813 cd/m² was observed. The spectral wavelength at this time is shown in FIG. 7. In this example, the measurement was carried out through the integrating sphere.

### Production Example 4

0.03 parts of phthalocyanine green were dispersed as a green coloring agent in silicone rubber, and a colored cap having a thickness of 0.5 mm was molded using a mold and a heat press.

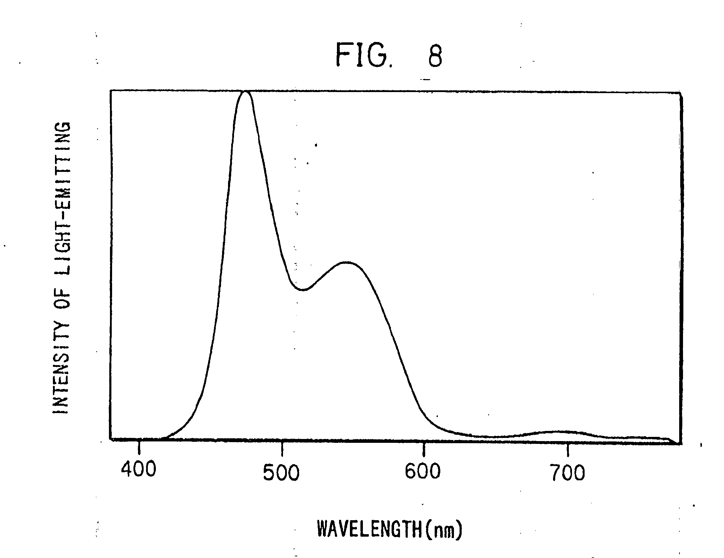

Similar to the production example 3, this colored cap was mounted on the LED having the fluorescent color cap mounted thereon, and the LED was caused to emit a li.ght. As a result, a diffused green light defined by x = 0.2127, y = 0.3702 in the chromaticity coordinate systems and having a luminance of 32.38 cd/m² was observed. The spectral wavelength at this time is shown in FIG. 8. In this example, the measurement was carried out through the integrating sphere.

### Production Example 5

A colored cap was molded in the same way as in the production example 4 except that an amount of the green coloring agent in use was changed from 40 parts to 80 parts. This colored cap was mounted on the LED having the fluorescent color cap mounted thereon, and the LED was caused to emit a light. As a result, a diffused green light defined by x = 0.1859, y = 0.3971 in the chromaticity coordinate systems and having a luminance of 22.34 cd/m² was observed. In this example, the measurement was carried out through the integrating sphere.

### Production Example 6

0.03 parts of phthalocyanine blue were dispersed as a blue coloring agent in silicone rubber, and a colored cap having a thickness of 0.5 mm was molded using a mold and a heat press.

Similar to the production example 3, this colored cap was mounted on the LED having the fluorescent color cap mounted thereon, and the LED was caused to emit a light. As a result, a diffused blue light defined by x = 0.1236, y = 0.1585 in the chromaticity coordinate systems and having a luminance of 10.19 cd/m² was observed. In this example, the measurement was carried out through the integrating sphere.

As is clear from the results of the production examples 3 to 6, a desired luminescent color can be obtained if a colored cap containing a coloring agent of a desired color is further mounted on the LED which is enabled to have a white luminescent color by mounting the fluorescent color cap.

### Production Example 7

40 parts of YAG fluophor (yttrium 28.0 wt%, aluminum 13.6 wt%, gadolinium 56.62 wt%, cerium 1.23 wt%) as fluorescent substance and 0.03 parts of condensation azo dye as a red coloring agent were dispersed in silicone rubber, and a fluorescent color cap having a thickness of 0.5 mm was produced using a mold and a heat press.

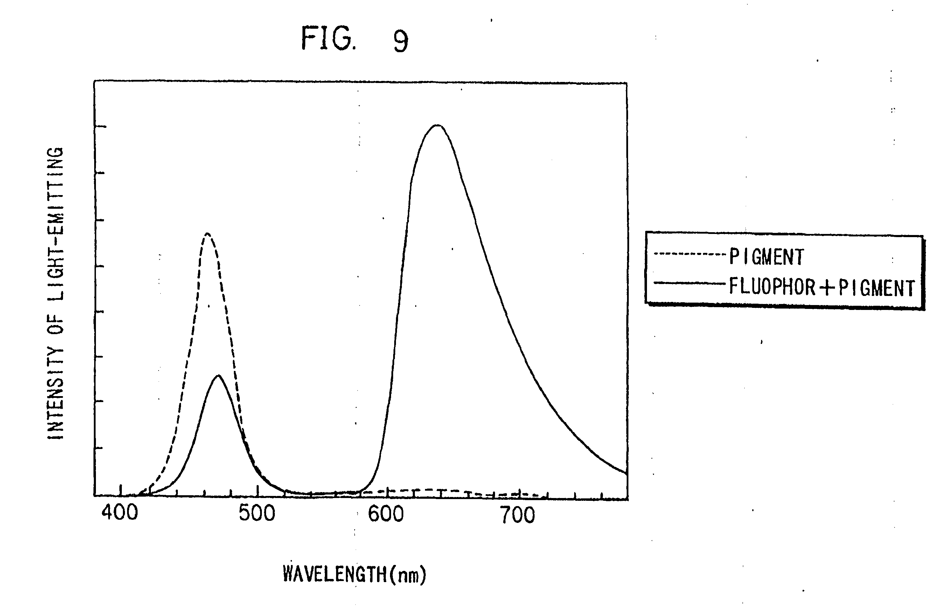

This fluorescent color cap was mounted on a blue LED, which was then caused to emit a light. Then, a blue light defined by x = 0.1275, y = 0.0883 in the chromaticity coordinate systems and having a luminance of 2.895 cd/m² became a diffused red light having a color defined by x = 0.5289, y = 0.2542 and a luminance of 0.9259 cd/m² after the mounting of the cap. A luminous intensity in relation to wavelength at this time is shown in FIG. 9. In this example, the measurement was carried out through the integrating sphere.

As is clear from the production example 7, a desired luminescent color can also be obtained by containing a coloring agent of a desired color in the fluorescent color cap.

### Production Example 8

23 parts of YAG fluophor (yttrium 28.0 wt%, aluminum 13.6wt%, gadolinium 56.62 wt%, cerium 1.23 wt%) were dispersed as fluorescent substance in silicone rubber, and a fluorescent color cap having a thickness of 0.35 mm was produced.

Using the blue LED used in the production example 1, the above cap was mounted on this blue LED, which was then turned on by applying a current of 20 mA. Lights emitted from the leading end portion and the side surface portion of the cap were measured by the spectrophotometer. The results are shown in TABLE-3. In this example, the measurement was carried out not through the integrating sphere.

**TABLE-3**

| Place of Measurement | X | y | Luminance (cd/m²) |
|---|---|---|---|
| Leading End | 0.2346 | 0.2365 | 2954 |
| Side Surface | 0.3095 | 0.3389 | 2053 |

Next, 12 parts of YAG fluophor (yttrium 28.0 wt%, aluminum 13.6wt%, gadolinium 56.62 wt%, cerium 1.23 wt%) were dispersed as fluorescent substance in silicone rubber, and a sheet piece having a thickness of 0.35 mm was produced. After mounting this sheet piece on the leading end of the cap, the chromaticity was measured again by the spectrophotometer. The result is shown in TABLE-4.

**TABLE-4**

| Place of Measurement | X | y | Luminance (cd/m²) |
|---|---|---|---|
| Leading End | 0.306 | 0.3355 | 2985 |

From these results, it can be seen that the chromaticity of the light diffused while passing through the coating member can be adjusted by changing the concentration of the fluorescent substance in the coating member.

### Production Example 9

Using a blue LED having a diameter of 3 mm, the color of the light emitted from this LED was changed by changing a value of a current flowing into the LED. A fluorescent color cap (thickness: 0.6 mm) containing a specific amount of YAG fluophor was mounted, and the luminescent color and the luminance after the mounting of the cap were measured by the spectrophotometer. The measurement results are shown in TABLE-5. In this example, the measurement was carried out through the integrating sphere.

**TABLE-5**

| Current mA | x | Y | Luminance | YAG Amount | x | y | Luminance |
|---|---|---|---|---|---|---|---|
| 5 | 0.1213 | 0.1063 | 9.71 | 5.0 | 0.2189 | 0.2320 | 14.11 |
| | | | | 10.0 | 0.2886 | 0.3165 | 20.51 |
| | | | | 15.0 | 0.3397 | 0.3767 | 23.85 |
| 10 | 0.1243 | 0.0972 | 16.48 | 5.0 | 0.2210 | 0.2216 | 29.85 |
| | | | | 10.0 | 0.2894 | 0.3076 | 40.66 |
| | | | | 10.5 | 0.2925 | 0.3105 | 43.39 |
| | | | | 15.0 | 0.3393 | 0.3694 | 43.67 |
| 20 | 0.1275 | 0.0883 | 28.95 | 5.0 | 0.2214 | 0.2132 | 53.23 |
| | | | | 10.0 | 0.2888 | 0.2991 | 70.99 |
| | | | | 11.0 | 0.2989 | 0.3102 | 78.56 |
| | | | | 15.0 | 0.3380 | 0.3612 | 81.28 |
| 30 | 0.1288 | 0.0848 | 38.51 | 5.0 | 0.2214 | 0.2094 | 71.30 |
| | | | | 10.0 | 0.2878 | 0.2957 | 96.22 |
| | | | | 11.5 | 0.3046 | 0.3124 | 111.00 |
| | | | | 15.0 | 0.3377 | 0.3577 | 109.99 |

From TABLE-5, it can be seen that, even if there is a variation in the luminescent color of the LED, the luminescent color can be adjusted within a specified range by mounting the fluorescent color cap containing the specific amount of fluorescent substance.

As described above, according to the inventive coating member containing the fluorescent substance, the luminescent color of the LED can be changed to a desired color including white by mounting this coating member on the LED.

Further, since the luminescent color is changed by exciting the wavelength of the light emitted from the LED by the fluorescent substance, a stable color balance can be obtained by a single LED. Further, since the cap-shaped coating member is molded, it is precise in dimension and easy to maintain. Furthermore, since this cap is directly mounted on the LED, no special space is necessary and can be mounted regardless of the shape of the LED.

## Claims

1. A transparent coating member (1, 10) to be engaged with the surface of a light-emitting diode (2), said transparent coating member (1, 10) being in a form of a cap and made of a silicone elastomer as a bonding resin and comprising, an inorganic fluorescent substance selected from a group consisting of aluminates, phosphates and silicates.

2. A transparent coating member (1, 10) according to claim 1, wherein the fluorescent substance is an inorganic aluminate.

3. A transparent coating member (1, 10) according to claim 1 or 2, wherein the fluorescent substance is an yttrium aluminate.

4. The transparent coating member (1, 10) according to anyone of claims 1 to 3, wherein an additive selected from the group consisting of cerium, europium, manganese, gadolinium, samarium, terbium, tin and chromium, is added to the fluorescent substance.

5. The transparent coating member (1, 10) according to claim 3, wherein the yttrium aluminate further includes cerium and gadolinium.

6. The transparent coating member (1, 10) according to anyone of claims 1 to 5, wherein the cap has a lens construction in which the leading end portion is thicker than the other portions.

7. A fluorescent color light source comprising:
a light-emitting diode (2); and
a transparent coating member (1, 10) engaged with the surface of the light-emitting diode (2),
said transparent coating member (1, 10) being in a form of a cap and made of a silicone elastomer as a bonding resin and comprising an inorganic fluorescent substance selected from a group consisting of aluminates, phosphates and silicates, whereby the wavelength of the light emitted by the light emitting diode (2) is changed by the fluorescence substance contained in the transparent coating member (1, 10) to change the luminescent color.

8. The fluorescent color light source according to claim 7, wherein the fluorescent substance is an inorganic aluminate.

9. The fluorescent color light source according to claim 7 or 8, wherein the fluorescent substance is an yttrium aluminate.

10. The fluorescent color light source according to anyone of claims 7 to 9, wherein an additive selected from the group consisting of cerium, europium, manganese, gadolinium, samarium, terbium, tin and chromium, is added to the fluorescent substance.

11. The fluorescent color light source according to claim 9, wherein the yttrium aluminate further includes cerium and gadolinium.

12. The fluorescent color light source according to anyone of claims 7 to 11, wherein the cap has a lens construction in which the leading end portion is thicker than the other portions.

13. The fluorescent color light source according to anyone of claims 7 to 12, wherein the light diffusely emitted through the transparent coating member (1, 10) has a luminescent color within a range defined by (x, y) = (0.148, 0,123), (0.199, 0.718), (0.651, 0.341) and (0.348, 0.623) in chromaticity coordinate systems.

14. The fluorescent color light source according to anyone of claims 7 to 12, wherein the light diffusely emitted through the transparent coating member (1, 10) has a luminescent color within a range defined by (x, y) = (0.27, 0.19), (0.19, 0.24), (0.35, 0.48) and (0.48, 0.37) in chromaticity coordinate systems.

15. The fluorescent color light source according to anyone of claims 7 to 14, further comprising a secondary coating portion mounted or formed on the coating member (1, 10), the secondary coating portion containing a coloring agent.

16. The fluorescent color light source according to anyone of claims 7 to 15, wherein the transparent coating member (1, 10) is separable from the light-emitting diode.

17. The fluorescent color light source according to claim 16, comprising a holder which detachably holds the transparent coating member (1, 10) and the light-emitting diode (2).

18. The fluorescent color light source according to anyone of claims 7 to 17, wherein the light-emitting diode (2) is a light-emitting diode which emits blue light.

19. The fluorescent color light source according to anyone of claims 7 to 17, wherein the light-emitting diode (2) is a light-emitting diode which emits green light.

## Patentansprüche

1. Transparentes Beschichtungselement (1, 10) zum Verbinden mit der Oberfläche einer Licht-emittierenden Diode (2), wobei das transparente Beschichtungselement (1, 10) in der Form einer Kappe vorliegt und aus einem Siliconelastomer als ein bindendes Harz hergestellt ist und eine anorganische fluoreszierende Substanz, ausgewählt aus einer Gruppe, bestehend aus Aluminaten, Phosphaten und Silikaten, umfaßt.

2. Transparentes Beschichtungselement (1, 10) nach Anspruch 1, wobei die fluoreszierende Substanz ein anorganisches Aluminat ist.

3. Transparentes Beschichtungselement (1, 10) nach Anspruch 1 oder 2, wobei die fluoreszierende Substanz ein Yttriumaluminat ist.

4. Transparentes Beschichtungselement (1, 10) nach einem der Ansprüche 1 bis 3, wobei ein Additiv, ausgewählt aus der Gruppe, bestehend aus Cer, Europium, Mangan, Gadolinium, Samarium, Terbium, Zinn und Chrom, zu der fluoreszierenden Substanz gegeben ist.

5. Transparentes Beschichtungselement (1, 10) nach Anspruch 3, wobei das Yttriumaluminat weiter Cer und Gadolinium einschließt.

6. Transparentes Beschichtungselement (1, 10) nach einem der Ansprüche 1 bis 5, wobei die Kappe eine Linsenkonstruktion aufweist, in welcher der Führungsendbereich dicker als die anderen Bereiche ist.

7. Fluoreszenzfarblichtquelle, umfassend:
eine Licht-emittierende Diode (2) und
ein transparentes Beschichtungselement (1, 10), verbunden mit der Oberfläche der Licht-emittierenden Diode (2),
wobei das transparente Beschichtungselement (1, 10) in der Form einer Kappe vorliegt und aus einem Siliconelastomer als ein bindendes Harz hergestellt ist und eine anorganische fluoreszierende Substanz, ausgewählt aus einer Gruppe, bestehend aus Aluminaten, Phosphaten und Silikaten, umfaßt, wobei die Wellenlänge des durch die Licht-emittierende Diode (2) emittierten Lichtes durch die fluoreszierende Substanz in dem transparenten Beschichtungselement (1, 10) verändert wird, um die Lumineszenzfarbe zu ändern.

8. Fluoreszenzfarblichtquelle nach Anspruch 7, wobei die fluoreszierende Substanz ein anorganisches Aluminat ist.

9. Fluoreszenzfarblichtquelle nach Anspruch 7 oder 8, wobei die fluoreszierende Substanz ein Yttriumaluminat ist.

10. Fluoreszenzfarblichtquelle nach einem der Ansprüche 7 bis 9, wobei ein Additiv, ausgewählt aus der Gruppe, bestehend aus Cer, Europium, Mangan, Gadolinium, Samarium, Terbium, Zinn und Chrom, zu der fluoreszierenden Substanz gegeben ist.

11. Fluoreszenzfarblichtquelle nach Anspruch 9, wobei das Yttriumaluminat weiter Cer und Gadolinium einschließt.

12. Fluoreszenzfarblichtquelle nach einem der Ansprüche 7 bis 11, wobei die Kappe eine Linsenkonstruktion aufweist, in welcher der Führungsendbereich dicker als die anderen Bereiche ist.

13. Fluoreszenzfarblichtquelle nach einem der Ansprüche 7 bis 12, wobei das durch das transparente Beschichtungselement (1, 10) diffus emittierte Licht eine Lumineszenzfarbe innerhalb eines Bereiches, definiert durch (x, y) = (0,148, 0,123), (0,199, 0,718), (0,651, 0,341) und (0,348, 0,623) in Farbart-Koordinatensystemen, aufweist.

14. Fluoreszenzfarblichtquelle nach einem der Ansprüche 7 bis 12, wobei das durch das transparente Beschichtungselement (1, 10) diffus emittierte Licht eine Lumineszenzfarbe innerhalb eines Bereiches, definiert durch (x, y) = (0,27, 0,19), (0,19, 0,24), (0,35, 0,48) und (0,48, 0,37) in Farbart-Koordinatensystemen, aufweist.

15. Fluoreszenzfarblichtquelle nach einem der Ansprüche 7 bis 14, welche weiter einen sekundären Beschichtungsbereich, aufgebracht oder gebildet auf dem Beschichtungselement (1, 10), umfaßt, wobei der sekundäre Beschichtungsbereich ein Färbemittel enthält.

16. Fluoreszenzfarblichtquelle nach einem der Ansprüche 7 bis 15, wobei das transparente Beschichtungselement (1, 10) von der Licht-emittierenden Diode abtrennbar ist.

17. Fluoreszenzfarblichtquelle nach Anspruch 16, umfassend einen Halter, der abnehmbar das transparente Beschichtungselement (1, 10) und die Licht-emittierende Diode (2) hält.

18. Fluoreszenzfarblichtquelle nach einem der Ansprüche 7 bis 17, wobei die Licht-emittierende Diode (2) eine Licht-emittierende Diode ist, welche blaues Licht emittiert.

19. Fluoreszenzfarblichtquelle nach einem der Ansprüche 7 bis 17, wobei die Licht-emittierende Diode (2) eine Licht-emittierende Diode ist, welche grünes Licht emittiert.

## Revendications

1. Elément de revêtement transparent (1, 10) à placer sur la surface d'une diode électroluminescente (2), ledit élément de revêtement transparent (1, 10) ayant la forme d'un capuchon et étant composé d'un élastomère de silicone en tant que résine de liante et comprenant une substance fluorescente inorganique sélectionnée dans un groupe composé d'aluminates, de phosphates et de silicates.

2. Elément de revêtement transparent (1, 10) selon la revendication 1, dans lequel la substance fluorescente est un aluminate inorganique.

3. Elément de revêtement transparent (1, 10) selon la revendication 1 ou 2, dans lequel la substance fluorescente est un aluminate d'yttrium.

4. Elément de revêtement transparent (1, 10) selon l'une quelconque des revendications 1 à 3, dans lequel un additif sélectionné dans le groupe composé du cérium, de l'europium, du manganèse, du gadolinium, du samarium, du terbium, de l'étain et du chrome, est ajouté à la substance fluorescente.

5. Elément de revêtement transparent (1, 10) selon la revendication 3, dans lequel l'aluminate d'yttrium comprend en outre le cérium et le gadolinium.

6. Elément de revêtement transparent (1, 10) selon l'une quelconque des revendications 1 à 5, dans lequel le capuchon possède une construction de lentille dans laquelle la partie d'extrémité principale est plus épaisse que les autres parties.

7. Source de lumière colorée fluorescente comprenant :
une diode électroluminescente (2) ; et
un élément de revêtement transparent (1, 10) placé sur la surface de la diode électroluminescente (2),
ledit élément de revêtement transparent (1, 10) ayant la forme d'un capuchon et étant composé d'un élastomère de silicone en tant que résine liante et comprenant une substance fluorescente inorganique sélectionnée dans un groupe composé d'aluminates, de phosphates et de silicates, moyennant quoi la longueur d'onde de la lumière émise par la diode électroluminescente (2) est modifiée par la substance fluorescente contenue dans l'élément de revêtement transparent (1, 10) afin de modifier la couleur luminescente.

8. Source de lumière colorée fluorescente selon la revendication 7, dans laquelle la substance fluorescente est un aluminate inorganique.

9. Source de lumière colorée fluorescente selon la revendication 7 ou 8, dans laquelle la substance fluorescente est un aluminate d'yttrium.

10. Source de lumière colorée fluorescente selon l'une quelconque des revendications 7 à 9, dans laquelle un additif sélectionné dans le groupe composé du cérium, de l'europium, du manganèse, du gadolinium, du samarium, du terbium, de l'étain et du chrome, est ajouté à la substance fluorescente.

11. Source de lumière colorée fluorescente selon la revendication 9, dans laquelle l'aluminate d'yttrium comprend en outre du cérium et du gadolinium.

12. Source de lumière colorée fluorescente selon l'une quelconque des revendications 7 à 11, dans laquelle le capuchon possède une construction de lentille dans laquelle la partie d'extrémité principale est plus épaisse que les autres parties.

13. Source de lumière colorée fluorescente selon l'une quelconque des revendications 7 à 12, dans laquelle la lumière émise de manière diffuse par l'intermédiaire de l'élément de revêtement transparent (1, 10) possède une couleur luminescente dans une plage définie par (x, y) = (0.148, 0.123), (0.199, 0.718), (0.651, 0.341) et (0.348, 0.623) dans des systèmes de coordonnées trichromatiques.

14. Source de lumière colorée fluorescente selon l'une quelconque des revendications 7 à 12, dans laquelle la lumière émise de manière diffuse par l'intermédiaire de l'élément de revêtement transparent (1, 10) possède une couleur luminescente dans une plage définie par (x,y) = (0.27, 0.19), (0.19, 0.24), (0.35, 0.48) et (0.48, 0.37) dans des systèmes de coordonnées trichromatiques.

15. Source de lumière colorée fluorescente selon l'une quelconque des revendications 7 à 14, comprenant en outre une partie de revêtement secondaire montée ou formée sur l'élément de revêtement (1, 10), la partie de revêtement secondaire contenant un agent colorant.

16. Source de lumière colorée fluorescente selon l'une quelconque des revendications 7 à 15, dans laquelle l'élément de revêtement transparent (1, 10) peut être séparé de la diode électroluminescente.

17. Source de lumière colorée fluorescente selon la revendication 16, comprenant un élément de fixation qui maintient de manière amovible l'élément de revêtement transparent (1, 10) et la diode électroluminescente (2).

18. Source de lumière colorée fluorescente selon l'une quelconque des revendications 7 à 17, dans laquelle la diode électroluminescente (2) est une diode électroluminescente qui émet une lumière bleue.

19. Source de lumière colorée fluorescente selon l'une quelconque des revendications 7 à 17, dans laquelle la diode électroluminescente (2) est une diode électroluminescente qui émet une lumière verte.
